# EUROPÄISCHE PATENTSCHRIFT

(11) **EP 2 799 947 B1**
(45) Veröffentlichungstag und Bekanntmachung des Hinweises auf die Patenterteilung: **23.03.2016**
(21) Anmeldenummer: 13166500.2
(22) Anmeldetag: 03.05.2013
(51) Int. Cl.: G05B 19/418, G05B 19/05, H05K 7/02

(54) **Anordnung mit einem ersten und einem zweiten Peripheriegerät**
Assembly with a primary and a secondary peripheral device
Agencement doté d'un premier et d'un deuxième appareils périphériques

(43) Veröffentlichungstag der Anmeldung: 05.11.2014
(73) Patentinhaber: Siemens Aktiengesellschaft, 80333 München (DE)
(72) Erfinder: Maier, Willi, 77728 Oppenau (DE); Rottmann, Norbert, 76829 Landau (DE)

(56) Entgegenhaltungen:
- US-B1- 6 549 034
- Anonymous: "SIMATIC PCS 7 Process Control System - Catalog ST PCS 7 - Chapter 8 - Process I/O", Siemens AG , Nr. E86060-D4001-A510-D1-7600 Juni 2012 (2012-06), Seiten U1-1,8/1-8/78, XP002706304, Gefunden im Internet: URL:https://www.automation.siemens.com/mcm s/process-control-systems/SiteCollectionDo cuments/efiles/pcs7/pdf/76/SIMATICPCS7_STP CS7_complete_English_2012-06.pdf [gefunden am 2013-07-26]

## Beschreibung

Die Erfindung betrifft eine Anordnung mit einem ersten und einem zweiten Peripheriegerät, die jeweils mit Prozessanschlüssen versehene Grundmodule zur Aufnahme von Elektronikmodulen aufweisen, wobei eine Redundanz-Adaptereinheit zum redundanten Anschluss eines Feldgerätes an jeweils ein Grundmodul der zwei Peripheriegeräte vorgesehen ist. Darüber hinaus betrifft die Erfindung eine Redundanz-Adaptereinheit für eine derartige Anordnung.

Eine solche Anordnung ist aus dem Siemens-Katalog "ST PCS 7 - Juni 2012", Prozessleitsystem SIMATIC PCS 7, Seiten 8/2 bis 8/6 bekannt. Die Peripheriegeräte dieser Anordnung sind jeweils mit einer Vielzahl von auf einen Träger montierbaren Baugruppen versehen und für die Anbindung der Prozessperipherie an ein oder mehrere Automatisierungsgeräte vorgesehen. Die Baugruppen umfassen gewöhnlich jeweils ein Grundmodul (Terminalmodul) sowie ein Elektronikmodul, z. B. ein Elektronikmodul in Form eines I/O-Moduls, welches auf das Grundmodul steckbar ist. Eine derartige Aufbautechnik mit so genannter "stehender Verdrahtung" unterstützt ein Ziehen und Stecken der I/O-Peripheriemodule in einem laufenden Betrieb. Dazu ist das jeweilige auf den Träger montierbare Grundmodul mit Leitungsanschlüssen bzw. Kanälen für die Verdrahtung von Prozessleitungen versehen, was bedeutet, dass an die jeweiligen Leitungsanschlüsse ein Sensor und/oder Aktor über eine geeignete Prozessleitung anschließbar ist.

Im Umfeld der Automatisierungstechnik werden verstärkt hochverfügbare Lösungen gefordert, welche geeignet sind, eventuell auftretende Stillstandszeiten der Anlage auf ein Minimum zu reduzieren. Dazu ist es erforderlich, sowohl neben der CPU bzw. Zentraleinheit eines Automatisierungsgerätes auch die Baugruppen des Peripheriegerätes oder der Peripheriegeräte redundant auszubilden. Daher werden im Hinblick auf die Peripheriegeräte zu verarbeitende Signale eines Sensors an zwei Baugruppen oder Steuersignale für einen Aktor gleichzeitig von zwei Baugruppen diesem Aktor übermittelt, wobei die Verdrahtung in der Art und Weise bewerkstelligt wird, dass ein Leitungsanschluss eines Grundmoduls einer Baugruppe mit dem entsprechenden bzw. identischen oder übereinstimmenden Leitungsanschluss eines Grundmoduls der anderen Baugruppe mittels einer Leitung verbunden bzw. kurzgeschlossen und an einen dieser beiden Leitungsanschlüsse die Sensor- oder Aktor-Leitung angeschlossen wird. Die Begriffe "entsprechend, identisch sowie übereinstimmend" beziehen sich in diesem Zusammenhang sowohl auf die Anzahl, die Positionierung, den Verwendungszweck als auch auf die mechanische und elektrische Ausbildung der Leitungsanschlüsse der Grundmodule.

Für den Fall, dass ein Feldgerät (Sensor, Aktor, Messumformer) redundant an eine Baugruppe eines ersten Peripheriegerätes und an eine Baugruppe eines zweiten Peripheriegerätes betrieben werden soll, kann ein so genanntes aus dem genannten Siemens-Katalog "ST PCS 7" bekanntes MTA-Terminalmodul eingesetzt werden. Die Baugruppen werden über zwei Kabel in Form einer Y-Verkabelung an das Terminalmodul angeschlossen, mit welchem prozessseitig das Feldgerät über ein Anschlusskabel verbunden ist. Nachteilig ist, dass dieses MTA-Terminalmodul gewöhnlich auf eine Hutschiene montiert wird und daher für dieses Modul ein gesonderter Platz in einem Schaltschrank bzw. in einer Anlage vorzusehen ist.

Der Erfindung liegt daher die Aufgabe zugrunde, in einer Anordnung der eingangs genannten Art die Redundanzverschaltung von Baugruppen, die in räumlich getrennten Peripheriegeräten angeordnet sind, zu vereinfachen. Darüber hinaus ist für eine derartige Anordnung eine geeignete Redundanz-Adaptereinheit zu schaffen.

Diese Aufgabe wird im Hinblick auf die Anordnung durch die im kennzeichnenden Teil des Anspruchs 1 angegebenen, bezüglich der Redundanz-Adaptereinheit durch die im kennzeichnenden Teil des Anspruchs 2 angegebenen Maßnahmen gelöst.

Vorteilhaft ist, dass mittels der Redundanz-Adaptereinheit sowohl zwei Baugruppen innerhalb eines Peripheriegerätes als auch zwei Baugruppen von zwei verschiedenen Peripheriegeräten redundant verschaltet werden können, wobei im Unterschied zum Stand der Technik kein zusätzlicher Platzbedarf für ein MTA-Terminalmodul erforderlich ist. Das Anschlussmodul belegt ein ohnehin vorhandenes Grundmodul, wobei in dem einen Peripheriegerät, in welchem das Anschlussmodul montiert ist, sofort für einen Anwender erkennbar ist, welche Baugruppe redundant mit einer weiteren verschaltet ist. Ferner ist es vorteilhaft, dass lediglich ein Kabel zum Verbinden des Anschlussmoduls mit der Baugruppe des anderen Peripheriegerätes erforderlich ist.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
Figur 1 eine Anordnung mit zwei Peripheriegeräten und
Figur 2 Baugruppen von Peripheriegeräten.

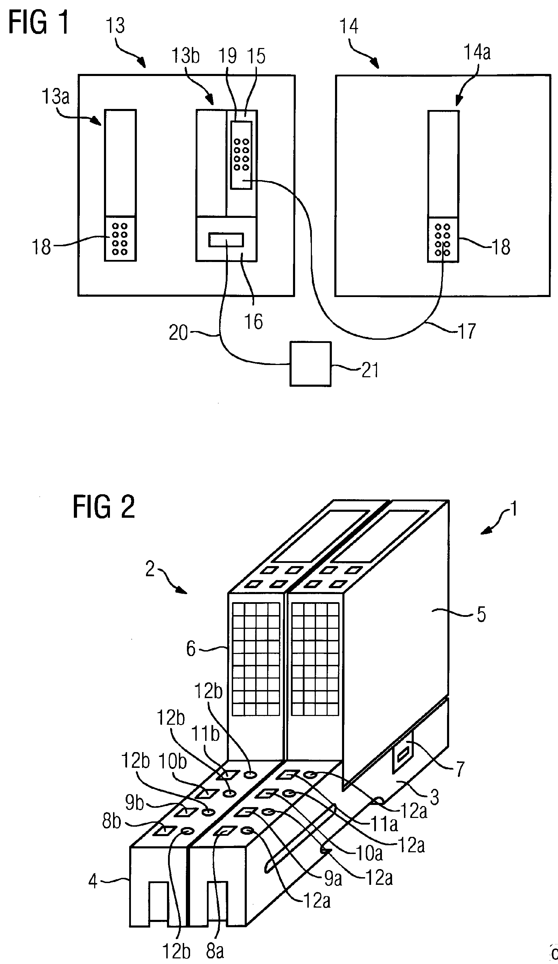

Es wird zunächst auf Figur 2 verwiesen, in welcher zwei auf einem hier nicht dargestellten Träger montierbare Baugruppen 1, 2 dargestellt sind. Diese können in einem Peripheriegerät oder räumlich getrennt jeweils in einem von zwei Peripheriegeräten angeordnet sein. Die Baugruppen 1, 2 weisen jeweils ein Grundmodul 3, 4 auf, welches z. B. mit einem Elektronikmodul in Form eines Eingabemoduls 5, 6 bestückt ist. Die Grundmodule und somit die Baugruppen der Peripheriegeräte sind über einen Bus miteinander verbunden, was im vorliegenden Ausführungsbeispiel mit Busverbindungsmittel 7 angedeutet ist. Jedes Grundmodul 3, 4 weist im vorliegenden Ausführungsbeispiel vier übereinstimmende Prozess- bzw. Leitungsanschlüsse 8a bis 11a, 8b bis 11b zum Anschluss von vier hier nicht dargestellten Sensoren über Sensor-Leitungen auf, die mittels Schrauben 12a, 12b in den Leitungsanschlüssen 8a bis 11a, 8b bis 11b befestigt werden. Selbstverständlich können andere Verbindungstechniken, z. B. Federklemmen, zum Anschluss der Leitungen an die Grundmodule vorgesehen werden. Über geeignete elektrische Verbindungen der Grundmodule 3, 4 kontaktieren die jeweiligen Leitungsanschlüsse 8a bis 11a mit dem Eingabemodul 5 und die jeweiligen Leitungsanschlüsse 8b bis 11b mit dem Eingabemodul 6.

Um einen Sensor redundant an die Leitungsanschlüsse von zwei Grundmodulen bzw. zwei Baugruppen räumlich getrennter Peripheriegeräte einfach anschließen zu können, ist eine Redundanz-Adaptereinheit vorgesehen.
Zur näheren Erläuterung wird im Folgenden auf Figur 1 verwiesen, in welcher eine Anordnung mit zwei Peripheriegeräten dargestellt ist. Ein erstes und zweites Peripheriegerät 13, 14 weist eine Vielzahl von Baugruppen auf, die - wie beschrieben - jeweils aus einem mit Prozessanschlüssen versehenen Grundmodul und einem auf das Grundmodul gesteckten Elektronikmodul bestehen, wobei die Grundmodule über einen hier nicht dargestellten Bus miteinander verbunden sind. Der Einfachheit halber sind im vorliegenden Ausführungsbeispiel lediglich Baugruppen 13a, 13b des ersten Peripheriegerätes 13 und eine Baugruppe 14a des zweiten Peripheriegerätes 14 dargestellt. Eine Redundanz-Adaptereinheit weist ein Anschlussmodul 15, einen Redundanz-Adapter 16, welcher auf die Prozessanschlüsse des Grundmoduls der Baugruppe 13b sowie auf das Grundmodul des Anschlussmoduls 15 gesteckt ist, und ein an dieses Anschlussmodul 15 angeschlossenes Verbindungskabel 17 auf. Dieses Verbindungskabel 17 verbindet die Prozessanschlüsse 18 des Grundmoduls der Baugruppe 14a mit dazu korrespondierenden Anschlüssen 19 des Anschlussmoduls 15, wobei das Verbindungskabel 17 einen Stecker zum Anschließen an die Prozessanschlüsse der Baugruppe 14a aufweist. Die Anschlüsse 19 sind wiederum mit den dazu korrespondierenden Prozessanschlüssen des Grundmoduls des Anschlussmoduls 15 verschaltet, die wiederum mittels des Redundanz-Adapters 16 mit den dazu korrespondierenden Prozessanschlüssen des Grundmoduls der Baugruppe 13b verschaltet sind. Mit anderen Worten: Mittels des Redundanz-Adapters 16, des Anschlussmoduls 15 und des Verbindungskabels 17 sind die Prozess- bzw. Leitungsanschlüsse des Grundmoduls der Baugruppe 13b des ersten Peripheriegerätes 13 mit den entsprechenden Prozessanschlüssen 18 des Grundmoduls der Baugruppe 14a des zweiten Peripheriegerätes 14 verbunden, wodurch ein über ein Kabel 20 an den Redundanz-Adapter 16 angeschlossener Sensor 21 redundant an die Baugruppen 13a, 14a angeschlossen ist.
Selbstverständlich kann das mit den Anschlüssen 19 versehene Anschlussmodul 15, welches im Hinblick auf dessen Dimensionierung der eines Elektronikmoduls entspricht, als Anschlussstecker ausgebildet sein. In diesem Fall muss sichergestellt werden, dass der Stecker "richtig" auf das Grundmodul gesteckt wird, sodass die Anschlüsse dieses Steckers mit den zu diesen Anschlüssen korrespondierenden Anschlüssen des Grundmoduls kontaktieren.

Mittels der Redundanz-Einheit kann selbstverständlich der Sensor 21 auch redundant mit zwei Baugruppen des Peripheriegerätes 13 oder 14 angeschlossen werden. Für den Fall, dass der Sensor 21 mit den Baugruppen 13a, 13b redundant zu verbinden ist, wird das Kabel 17 anstatt an die Prozessanschlüsse 18 an Prozessanschlüsse des Grundmoduls der Baugruppe 13 angeschlossen.
Falls der Sensor 21 redundant an die Baugruppe 13b und an eine zu dieser Baugruppe 13b direkt benachbart angeordnete Baugruppe anzuschließen ist, kann auf das Anschlussmodul 15 und das Verbindungskabel 17 verzichtet werden. In diesem Fall kontaktiert der Redundanz-Adapter 16 mit den Prozessanschlüssen des Grundmoduls der Baugruppe 13a mit dem Grundmodul der benachbarten Baugruppe. Beispielsweise wird anstatt des Anschlussmoduls 15 ein Elektronikmodul auf das Grundmodul gesteckt, wodurch die Prozessanschlüsse dieser Baugruppe mit denen der Baugruppe 13b verschaltet sind.

Die Erfindung lässt sich daher wie folgt zusammenfassen:
Ein Anordnung mit einem ersten und einem zweiten Peripheriegerät 13, 14, die jeweils mit Prozessanschlüssen 18 versehene Grundmodule 3, 4 zur Aufnahme von Elektronikmodulen 5, 6 aufweisen, wobei eine Redundanz-Adaptereinheit zum redundanten Anschluss eines Feldgerätes 21 an jeweils eines der Grundmodule der zwei Peripheriegeräte 13, 14 vorgesehen ist, zeichnet sich dadurch aus, dass die Redundanz-Adaptereinheit aufweist:
   - einen Redundanz-Adapter 16 zum Anschließen des Feldgerätes 21 und zum direkten Kontaktieren mit den Prozessanschlüssen 18 des Grundmoduls eines der Peripheriegeräte 13 sowie mit den Prozessanschlüssen eines diesem Grundmodul benachbarten Grundmoduls,
   - ein Anschlussmodul 15 oder einen Anschlussstecker zum Kontaktieren mit einem der mit dem Redundanz-Adapter 16 kontaktierten Grundmodule des einen Peripheriegerätes 13, und
   - ein mit dem Anschlussmodul 15 oder dem Anschlussstecker kontaktiertes Verbindungskabel 17 zum Anschließen an die Prozessanschlüsse 18 des Grundmoduls des anderen Peripheriegerätes 14.

Mittels derartiger Maßnahmen wird die Redundanzverschaltung von Baugruppen 13b, 14a, die in räumlich getrennten Peripheriegeräten 13, 14 angeordnet sind, vereinfacht.

## Patentansprüche

1. Anordnung mit einem ersten und einem zweiten Peripheriegerät (13, 14), die jeweils mit Prozessanschlüssen (18) versehene Grundmodule (3, 4) zur Aufnahme von Elektronikmodulen (5, 6) aufweisen, wobei eine Redundanz-Adaptereinheit zum redundanten Anschluss eines Feldgerätes (21) an jeweils eines der Grundmodule (3, 4) der zwei Peripheriegeräte (13, 14) vorgesehen ist, **dadurch gekennzeichnet, dass** die Redundanz-Adaptereinheit aufweist:
- einen Redundanz-Adapter (16) zum Anschließen des Feldgerätes (21) und zum direkten Kontaktieren mit den Prozessanschlüssen (18) des Grundmoduls eines der Peripheriegeräte (13) sowie mit den Prozessanschlüssen (18) eines diesem Grundmodul benachbarten Grundmoduls (3, 4),
- ein Anschlussmodul (15) oder einen Anschlussstecker zum Kontaktieren mit einem der mit dem Redundanz-Adapter (16) kontaktierten Grundmodule des einen Peripheriegerätes (13), und
- ein mit dem Anschlussmodul (15) oder dem Anschlussstecker kontaktiertes Verbindungskabel (17) zum Anschließen an die Prozessanschlüsse (18) des Grundmoduls des anderen Peripheriegerätes (14).

2. Redundanz-Adaptereinheit für eine Anordnung nach Anspruch 1, wobei die Anordnung mit einem ersten und einem zweiten Peripheriegerät (13, 14) versehen ist, die jeweils mit Prozessanschlüssen (18) versehene Grundmodule (3, 4) zur Aufnahme von Elektronikmodulen (5, 6) aufweisen, wobei eine Redundanz-Adaptereinheit zum redundanten Anschluss eines Feldgerätes (21) an jeweils eines der Grundmodule der zwei Peripheriegeräte (13, 14) vorgesehen ist, **dadurch gekennzeichnet, dass** die Redundanz-Adaptereinheit aufweist:
- einen Redundanz-Adapter (16) zum Anschließen des Feldgerätes (21) und zum direkten Kontaktieren mit den Prozessanschlüssen (18) des Grundmoduls eines der Peripheriegeräte (13) sowie mit den Prozessanschlüssen (18) eines diesem Grundmodul benachbarten Grundmoduls (3, 4),
- ein Anschlussmodul (15) oder einen Anschlussstecker zum Kontaktieren mit einem der mit dem Redundanz-Adapter (16) kontaktierten Grundmodule des einen Peripheriegerätes (13), und
- ein mit dem Anschlussmodul (15) oder dem Anschlussstecker kontaktiertes Verbindungskabel (17) zum Anschließen an die Prozessanschlüsse (18) des Grundmoduls des anderen Peripheriegerätes (14).

## Claims

1. Arrangement having a first peripheral device (13) and a second peripheral device (14) each having basic modules (3, 4) which are provided with process connections (18) and are intended to accommodate electronic modules (5, 6), a redundancy adapter unit being provided for redundantly connecting a field device (21) to one of the basic modules (3, 4) of the two peripheral devices (13, 14) in each case, **characterized in that** the redundancy adapter unit has:
- a redundancy adapter (16) for connecting the field device (21) and for making direct contact with the process connections (18) of the basic module of one of the peripheral devices (13) and with the process connections (18) of a basic module (3, 4) adjacent to this basic module,
- a connection module (15) or a connection plug for making contact with one of the basic modules of one peripheral device (13) with which the redundancy adapter (16) makes contact, and
- a connecting cable (17) which makes contact with the connection module (15) or the connection plug and is intended for connection to the process connections (18) of the basic module of the other peripheral device (14).

2. Redundancy adapter unit for an arrangement according to Claim 1, the arrangement being provided with a first peripheral device (13) and a second peripheral device (14) each having basic modules (3, 4) which are provided with process connections (18) and are intended to accommodate electronic modules (5, 6), a redundancy adapter unit being provided for redundantly connecting a field device (21) to one of the basic modules of the two peripheral devices (13, 14) in each case, **characterized in that** the redundancy adapter unit has:
- a redundancy adapter (16) for connecting the field device (21) and for making direct contact with the process connections (18) of the basic module of one of the peripheral devices (13) and with the process connections (18) of a basic module (3, 4) adjacent to this basic module,
- a connection module (15) or a connection plug for making contact with one of the basic modules of one peripheral device (13) with which the redundancy adapter (16) makes contact, and
- a connecting cable (17) which makes contact with the connection module (15) or the connection plug and is intended for connection to the process connections (18) of the basic module of the other peripheral device (14).

## Revendications

1. Agencement ayant un premier et un deuxième appareil (13, 14) périphérique qui, pour la réception de modules (5, 6) électroniques, ont respectivement des modules (3, 4) de base pourvus de bornes de processus, une unité d'adaptateur à redondance étant prévue pour le raccordement redondant d'un appareil (21) de terrain à respectivement l'un des modules (3, 4) de base des deux appareils (13, 14) périphériques, **caractérisé en ce que** l'unité d'adaptateur à redondance a:
- un adaptateur (16) à redondance pour le raccordement de l'appareil (21) de terrain et pour la mise en contact direct avec les bornes (18) de processus du module de base de l'un des appareils (13) périphériques ainsi qu'avec les bornes (18) de processus d'un module (3, 4) de base voisin de ce module de base,
- un module (15) de raccordement ou un connecteur de raccordement pour la mise en contact avec l'un des modules de base, mis en contact avec l'adaptateur (16) à redondance, de l'un des appareils (13) périphérique et
- un câble (17) de liaison mis en contact avec le module (15) de raccordement ou avec le connecteur de raccordement pour le raccordement aux bornes (18) de processus du module de base de l'autre appareil (14) périphérique.

2. Unité d'adaptateur à redondance pour un agencement suivant la revendication 1, dans laquelle l'agencement est pourvu d'un premier et d'un deuxième appareil (13, 14) périphériques qui ont, pour la réception de modules (5, 6) électroniques, respectivement des modules (3, 4) de base pourvus de bornes (18) de processus, une unité d'adaptateur à redondance étant prévue pour le raccordement redondant d'un appareil (21) de terrain à respectivement l'un des modules (3, 4) de base des deux appareils (13, 14) périphériques, **caractérisé en ce que** l'unité d'adaptateur à redondance a:
- un adaptateur (16) à redondance pour le raccordement de l'appareil (21) de terrain et pour la mise en contact direct avec les bornes (18) de processus du module de base de l'un des appareils (13) périphériques ainsi qu'avec les bornes (18) de processus d'un module (3, 4) de base voisin de ce module de base,
- un module (15) de raccordement ou un connecteur de raccordement pour la mise en contact avec l'un des modules de base, mis en contact avec l'adaptateur (16) à redondance, de l'un des appareils (13) périphérique et
- un câble (17) de liaison mis en contact avec le module (15) de raccordement ou avec le connecteur de raccordement pour le raccordement aux bornes (18) de processus du module de base de l'autre appareil (14) périphérique.
